# EUROPÄISCHE PATENTANMELDUNG

(11) **EP 2 860 162 A1**
(43) Veröffentlichungstag der Anmeldung: **15.04.2015**
(21) Anmeldenummer: 14186399.3
(22) Anmeldetag: 25.09.2014
(51) Int. Cl.: C03C 17/00

(54) **Temperaturbeständiger transparenter elektrischer Leiter, Verfahren zur Herstellung und Verwendung**

(30) Priorität: 11.10.2013 DE 102013111267
(71) Anmelder: Schott AG, 55122 Mainz (DE)
(72) Erfinder: Riethmüller, Dr. Franziska, 60326 Frankfurt a.M. (DE); Bockmeyer, Dr. Matthias, 55116 Mainz (DE); Hoffmann, Dr. Ulf, 64319 Pfungstadt (DE)
(74) Vertreter: Fleck, Hermann-Josef

(57) **Zusammenfassung**

Die Erfindung betrifft einen transparenten elektrischen Leiter mit einem transparenten Substrat und einer elektrisch leitfähigen Schicht auf dem Substrat, wobei die leitfähige Schicht eine Vielzahl von elektrisch leitfähigen nanoskaligen Additiven aufweist, wobei die Additive miteinander in elektrisch leitender Verbindung stehen, um die elektrisch leitfähige Schicht zu bilden, wobei das Substrat von einem Glas- oder Glaskeramikwerkstoff oder einem Glas- und/oder Glaskeramik aufweisenden Verbundwerkstoff gebildet ist, wobei die Additive zumindest bereichsweise in einer Matrixschicht eingebettet sind, und wobei die Matrixschicht von einem transparenten Matrixmaterial gebildet ist. Um einen solchen transparenten elektrischen Leiter, insbesondere für die Anwendung in einem Display, als Touchsensor oder dergleichen, für Kochflächen verwendbar zu machen, ist es erfindungsgemäß vorgesehen, dass der transparente elektrische Leiter eine thermische Beständigkeit von mindestens 140 °C aufweist. Weiterhin ist es erfindungsgemäß vorgesehen, dass die Additive (4) in einem Matrixmaterial dispergiert werden, und dass das Matrixmaterial mit den darin dispergierten Additiven (4) als Beschichtungsmaterial auf das Substrat (1) in einem Beschichtungsschritt aufgebracht wird.

## Beschreibung

Die Erfindung betrifft einen transparenten elektrischen Leiter mit einem transparenten Substrat und einer leitfähigen Schicht auf dem Substrat, wobei die leitfähige Schicht eine Vielzahl von elektrisch leitfähigen, nanoskaligen Additiven aufweist, wobei die Additive miteinander bereichsweise in elektrisch leitender Verbindung stehen um eine elektrisch leitfähige Schicht zu bilden, wobei das Substrat von einem Glas- oder Glaskeramikwerkstoff oder einem Glas- und/oder Glaskeramik aufweisenden Verbundwerkstoff gebildet ist, wobei die Additive zumindest bereichsweise in eine Matrixschicht eingebettet sind, und wobei die Matrixschicht von einem transparenten Matrixmaterial gebildet ist.

Ein transparenter elektrischer Leiter besteht aus einem transparenten Substratmaterial, auf dem eine transparente leitfähige Schicht aufgebracht ist. Dabei zeichnet sich die transparente leitfähige Schicht durch eine gute elektrische Leitfähigkeit aus, wobei gleichzeitig eine hohe Transmission für Licht im sichtbaren Wellenlängenbereich vorliegt. Die elektrischen Leiter können als transparente Elektroden in LCD-Anzeigen, Touchpanels, Photovoltaikzellen, antistatischen Beschichtungen und EMV-Beschichtungen verbaut sein.

Aus dem Stand der Technik sind transparente elektrische Leiter bekannt, zu deren Fertigung eine Flüssigkeit, enthaltend elektrisch leitfähige nanoskalige Additive, auf eine Substratoberfläche aufgebracht wird. Nach US 8,049,333 B2 werden als Additive insbesondere metallische Nanodrähte eingesetzt. Anschließend wird die Flüssigkeit verdampft, sodass die Additive in Form eines Netzwerks auf dem Substrat aufliegen. Anschließend wird nach US 8,049,333 B2 ein Matrixmaterial auf die Additivschicht aufgebracht. Das Matrixmaterial kann dann mechanisch in die Additivschicht eingedrückt werden. Anschließend wird das Matrixmaterial ausgehärtet. Zur Durchführung des in der US 8,049,333 B2 beschriebene Verfahrens ist ein relativ hoher technischer Aufwand notwendig, v.a. dahingehend, dass zunächst die Additivschicht und darauffolgend in einem zweiten Beschichtungsschritt eine Schutzmatrix aufgebracht wird. Darüber hinaus weisen die mit dem in dieser Druckschrift beschriebenen Verfahren gefertigten elektrischen Leiter insbesondere bei Temperatureinwirkungen nicht die für bestimmte Anwendungen geforderte Langzeit- und Temperaturbeständigkeit auf.

Aus dem Stand der Technik sind auch Kochfelder bekannt, bei denen unter einer Scheibe bestehend aus Glas oder Glaskeramik elektrische Heizelemente angeordnet sind. Weiterhin sind auf der Rückseite der Glas- oder Glaskeramikscheibe Displays oder Touchsensoren angeordnet. Dabei werden beispielsweise ITO-Beschichtungen oder Schichten aus anderen transparenten leitfähigen Oxiden durch ein Sputter- oder Flüssigkeitsbeschichtungsverfahren auf die Rückseite der Glas oder Glaskeramikscheibe aufgebracht. Beispielsweise ist aus der US 7,309,405 ein Verfahren zur Erzeugung einer Beschichtung mit Zinn-dotiertem Indiumoxid (ITO) beschrieben. Eine solche Schicht weist eine hohe Transmission und gute elektrische Leitfähigkeit auf und kann über ein Sputterverfahren auf die Unterseite der Glaskeramik aufgebracht werden. Der technische Aufwand zur Erzeugung solcher Schichten ist ebenfalls sehr hoch. Aufgrund der schwindenden Verfügbarkeit von Indium sind Materialpreissteigerungen zu erwarten, die die Einsetzbarkeit dieses Verfahrens weiter in Frage stellen.

Aus der JP 2010 092 650 ist ein Kochfeld mit einem Touchfeld auf der Rückseite der Kochplatte beschrieben, welches aus einer transparenten leitfähigen Schicht, bestehend aus einem Halbleiteroxid und einer zusätzlichen transparenten Schutzschicht besteht.

Die DE 10 2009 053 688 offenbart eine siebdruckfähige, transparente, leitfähige Beschichtungslösung. Sie ist mit Indium und einer Zinnverbindung versetzt und eignet sich zur Bildung von ITO-Schichten. Solche Beschichtungslösungen weisen einen zu hohen Flächenwiderstand auf. Die Beschichtungen müssen eingebrannt werden, sodass kein vorgespanntes Glassubstrat verwendbar ist. Weiterhin kann die Schicht während eines thermischen Vorspannprozesses nicht eingebrannt werden.

Schließlich ist es bei Kochfeldanwendungen bekannt, Folien mit leitfähigen Strukturen zu bedrucken. Solche Folien können dann auf der Unterseite des Kochfeldes auflaminiert werden. Dabei besteht allerdings die Gefahr, dass bei einem Versagen des Klebers unter Wechselwirkung mit der Atmosphäre Delaminierungen auftreten können. Weiterhin ist es aufwändig, die Folie blasenfrei mit der Unterseite der Kochfläche zu verkleben.

Es ist Aufgabe der Erfindung, einen transparenten elektrischen Leiter der eingangs erwähnten Art bereitzustellen, der auch unter Temperatureinwirkung eine ausreichend hohe Standzeit aufweist. Weiterhin ist es Aufgabe der Erfindung, einen transparenten elektrischen Leiter in einem einfachen Verfahren, vorzugsweise mit nur einem Beschichtungsschritt pro transparenter leitfähiger Schicht, herzustellen.

Diese Aufgabe wird dadurch gelöst, dass das Substrat- und das Matrixmaterial aus Werkstoffen bestehen, die eine thermische Beständigkeit von mindestens 140° C aufweisen. Damit lässt sich ein transparenter elektrischer Leiter gestalten, der insbesondere für die Kochflächenanwendung geeignet ist und dort insbesondere im Kaltbereich einer Kochfläche einsetzbar ist. Er kann dort zur Gestaltung eines Displays oder eines Touchsensors verbaut sein. Ein auf der Oberseite der Kochfläche aufgesetzter heißer bzw. überhitzter Topf schädigt den transparenten elektrischen Leiter nicht. Vielmehr weist dieser eine ausreichend hohe Dauerfestigkeit und Beständigkeit auf.

Vorzugsweise weisen das Substrat und das Matrixmaterial eine thermische Beständigkeit von mindestens 140° C, bevorzugt mindestens 180°C, besonders bevorzugt mindestens 200° C auf, sodass der elektrische Leiter insbesondere im Kaltbereich einer Kochfläche positioniert sein kann.

Gemäß einer bevorzugten Erfindungsvariante kann es vorgesehen sein, dass die Kratzbeständigkeit des Matrixmaterials mindestens 500g, vorzugsweise mindestens 700g gemessen nach dem Sklerometertest (Elcometer 3092 Härteprüfstab mit 1,0 mm Wolframkarbidspitze) aufweist. Hierdurch wird sichergestellt, dass der transparente elektrische Leiter eine ausreichend hohe mechanische Festigkeit aufweist. Insbesondere ist er dann kratzbeständig. Dies ist besonders bei Kochflächen von Vorteil, da diese während des Einbauvorgangs der Kochfläche in den Herd stark mechanisch belastet werden können. So kann es beispielsweise vorkommen, dass die scharfen Kanten der Metallhalterungen bei diesem Prozess die Beschichtung berühren.

Weiterhin sollte der transparente elektrische Leiter für die Anwendung bei einer Kochfläche auch eine ausreichende Beständigkeit gegen Wasserdampf aufweisen, da dieser hochkorrosiv sein kann. Für die Anwendung bei einer Kochfläche soll daher das Matrixmaterial so gewählt sein, dass eine Beständigkeit gegen Wasserdampf von bis zu einer Stunde gewährleistet ist (getestet über einem Topf mit kochendem Wasser). Darüber hinaus sollte auch einer Alterungsbeständigkeit gegeben sein, wobei der Flächenwiderstand des elektrischen Leiters sich nicht mehr als 25 %, vorzugsweise nicht mehr als 10 % über 10 Jahre erhöht.

Insbesondere bei der Anwendung für Displays sollte das Matrixmaterial eine Lichttransmission im sichtbaren Bereich (400 nm ≤ λ ≤ 700 nm) größer als 90 %, vorzugsweise größer als 95 % aufweisen (gemäß ASTM D 1003).

Um keine zu hohe Störung der Durchsicht durch den transparenten elektrischen Leiter hervorzurufen, sollte der Haze-Wert des Matrixmaterials kleiner als 5 %, bevorzugt kleiner als 3 %, besonders bevorzugt kleiner als 1 % betragen. Der Haze-Wert ist ein Maß für die Trübung von transparenten Proben. Dieser Wert beschreibt den Anteil des transmittierten Lichtes der von der durchstrahlten Probe gestreut oder reflektiert wird. Somit quantifiziert der Haze-Wert Materialfehler in der Oberfläche oder der Struktur des Matrixmaterials.

Als leitfähige Additive können beispielsweise metallische Nanodrähte oder Nanoröhren zum Einsatz kommen. Diese garantieren eine gute elektrische Leitfähigkeit, wobei eine hohe Transmission aufgrund der nanoskaligen Abmessungen erhalten bleibt. Als nanoskalig werden dabei Additive definiert, deren Größe in mindestens einer Dimension 200 Nanometer oder weniger beträgt. Die Kombination von faserartigen leitfähigen Additiven zusammen mit ihrem geringen nanoskaligen Durchmesser ermöglicht die Ausbildung von leitfähigen Netzwerken. Der elektrische Widerstand kann dabei durch die Menge der leitfähigen Additive gezielt eingestellt werden. Während bei Verwendung von Additiven mit geringem Aspektverhältnis sehr hohe Additivdosierungen (bis zu 50 Masse-%) zur Ausbildung von Leitfähigkeitspfaden notwendig sind, liegt die so genannte Perkolationsschwelle, also die kritische Konzentration an Additiven, bei der die Leitfähigkeit des (Schicht-)Materials sprunghaft ansteigt, bei Additiven mit höherem Aspektverhältnis bei deutlich niedrigeren Konzentrationen.

Geeignete Matrixmaterialien sind beispielsweise UV- oder thermisch härtbare Polymere, UV oder thermisch organisch vernetzbare hybridpolymere Sol-Gel-Materialien, Hybridpolymere Sol-Gel-Materialien, Nanopartikelfunktionalisierte Sol-Gel-Materialien, Sol-Gel-Materialien mit nanopartikulären Füllstoffen und/oder anorganische Sol-Gel-Materialien.

Für die Herstellung eines erfindungsgemäßen transparenten elektrischen Leiters mit transparenter leitfähiger Schicht sind die hochleitfähigen Additive in einer flüssigen Matrixvorstufe dispergiert und werden in einem Beschichtungsschritt zusammen mit dem Matrixmaterial auf das Substrat aufgebracht. Dabei ist die Matrix so ausgeführt, dass die hochleitfähigen Additive in ihr dispergiert werden können. Gleichzeitig legt sich die Matrix aber nicht vollständig um die Leitfähigkeitsadditive, sodass die Matrix die Leitfähigkeitsadditive nicht voneinander elektrisch isoliert.

Die thermische Beständigkeit des Matrixmaterials kann in Temper-Versuchen bei den entsprechenden Temperaturen (erfindungsgemäß ≥ 140° C) für 2 Stunden überprüft werden. In einer speziellen Ausführungsform der Erfindung schützt die Matrix die hochleitfähigen Additive vor Degradation (Schutz vor Sauerstoff, Schwefel, H₂O, Säureangriff) bzw. Korrosion. Hierdurch wird die Langzeitbeständigkeit der Leitfähigkeit des beschichteten Substrats sichergestellt.

Bevorzugt wird zur Herstellung eines erfindungsgemäßen elektrischen Leiters das Substrat mit einer Beschichtungslösung, z.B. einer Siebdruckfarbe, bestehend aus einem matrixbildenden Material und hochleitfähigen Additiven und gegebenenfalls weiteren Zusatzstoffen (Dispergiermitteln, Oberflächenreaktanten (Surfactants), Lösungsmittel, Verdicker, Verlaufshilfsmittel, Entlüfter, Entschäumer, Härter, Starter, Korrosionsinhibitoren, Haftvermittler...) beschichtet.

Als Lösungsmittel können hochsiedende Lösungsmittel mit einem niedrigen Dampfdruck von < 5 bar, bevorzugt < 1 bar, besonders bevorzugt < 0,1 bar eingesetzt werden. Es werden bevorzugt Lösungsmittel zugesetzt, welche einen Siedepunkt von mehr als 120°C und eine Verdunstungszahl von >10 haben. Vorzugsweise wird ein Lösungsmittel mit einem Siedepunkt über 150°C und einer Verdunstungszahl von >500, besonders bevorzugt mit einem Siedepunkt über 200°C und einer Verdunstungszahl von >1000 verwendet. Derartige hoch siedende Lösungsmittel sind insbesondere Glykole und Glykolether, Terpene und Polyole, sowie Mischungen aus mehreren dieser Lösungsmittel. Es können Butylacetat, Methoxybutylacetat, 2-(2-Butoxyethoxy)ethylacetat (Carpitolacetat), 2-Butoxyethylacetat, Butylcarbitolacetat F4789, Butyldiglykol, Butyldiglykolacetat, Butylglykol, Butylglykolacetat, Cyclohexanon, Diacetonalkohol, Diethylenglykol, Dipropylenglykolmonomethylether, Dipropylen-glykolmonobuthylether, Propylenglykolmonobutylether, Propylenglykolmonopropylether, Propylenglykolmonoethylether, Ethoxypropylacetat, Hexanol, 1,3-Diethoxy-2-propanol, 1,5-Pentandiol, 1-Methoxy-2-propanol, 4-Hydroxy-4-methyl-2-pentanon, Acetessigsäureethylester, N,N-Dimethylacetamid, Polyethylenglycol 200, Propylencarbonat, Methoxypropylacetat, Mono-ethylenglykol, Ethylpyrrolidon, Methylpyrrolidon, Dipropylenglykoldimethylether, Propylenglykol, Propylenglykolmonomethylether, Gemische aus parafinischen und naphthenischen Kohlenwasserstoffen, aromatische Kohlenwasserstoffgemische, Mischungen aromatischer alkylkierter Hydrocarbone und Gemische von n-, i- und cyclo-Aliphaten als Lösungsmittel verwendet werden. Insbesondere können Polyethylenglykolether, wie beispielsweise Diethylenglykolmonoethylether, Tripropylenglykolmonomethylether und Terpineol als Lösungsmittel verwendet werden. Weiterhin können Mischungen aus zwei oder mehreren dieser Lösungsmittel verwendet werden. Hierbei können die Lösungsmittel sowohl der Matrixvorstufe als auch der Lösung der nanoskaligen Additive zugegeben werden.

Um die Applikation des Beschichtungsmaterials, insbesondere der Beschichtungslösung, mit verschiedenen Auftrags- bzw. Druckverfahren zu ermöglichen, liegen die nanoskaligen Additive und/oder das Matrixmaterial als Matrixvorstufe vor dem Zusammenführen in dem Beschichtungsmaterial beide in mindestens einem niedrigsiedenden, mindestens einem hochsiedendem Lösungsmittel oder in einem Lösungsmittelgemisch bestehend aus mindestens einem niedrigsiedendem und mindestens einem hochsiedendem Lösungsmittel vor. Niedrigsiedende Lösungsmittel haben einen Siedepunkt von unter, hochsiedende Lösungsmittel einen Siedepunkt von über 120 °C.

Für die Anwendung an Kochflächen eignen sich als Matrixmaterialien UV- oder thermisch härtbare Polymere, wie bspw. Polyvinylalkohol, Polyvinylacetale, Polyvinylpyrrolidon, Polyolefine, Polycarbonat, Polyethylenterephthalat, perfluorierte Polymere, bspw. Polytetrafluorethylen, Polyurethane, bspw. silikonmodifizierte Polyurethane, Polyester, Epoxydharze, Methacrylatharze, Polyimide, Cycloolefincopolymere, Polyethersulfon und Mischungen dieser Bestandteile, Polysiloxane, wie bspw. Methyl-Polysiloxan, Phenyl-Polysiloxane, Methyl/Phenyl-Polysiloxane, Polysiloxane, bzpw. acrylatmodifizierte, polyestermodifizierte, polyurethanmodifizierte, epoxidmodifizierte oder nanopartikelfunktionalisierte Polysiloxane und/oder Silikone, Silikonharze, polyestermodifizierte, polyethermodifizierte oder epoxidfunktionalisierte Silikonharze, Silaxane, Silazane, SiliXane, Polysilsesquioxane, UV- oder thermisch organisch vernetzbare hybridpolymere Sol-Gel-Materialien, hybridpolymere Sol-Gel-Materialien, nanopartikelfunktionalisierte Sol-Gel-Materialien, Sol-Gel-Materialien mit nanopartikulären Füllstoffen bzw. anorganische Sol-Gel-Materialien. Dabei handelt es sich bei nanopartikulären Füllstoffen um Additive, die nicht in das Sol-Gel-Netzwerk eingebaut werden, wohingegen Nanopartikel in nanopartikelfunktionalisierten Sol-Gel-Materialien reaktiv in das Matrixnetzwerk eingebaut sind.

Der Beschichtungslösung können beispielsweise UV-aktivierbare oder thermische Starter für kationische oder radikalische Polymerisation wie Triarylsulphoniumsalze, Diaryliodiniumsalze (z.B. Irgacure 250), Ferroceniumsalze, Benzoinderivate, α-Hydroxyalkylphenone (z.B. Irgacure 184), α-Aminoacetophenone (z.B. 2-Methyl-1[4-(methylthio)phenyl]-2-morpholinopropanone), Acylphosphinoxide (z.B. Irgacure 819) oder 1,5-Diazabicyclo[4.3.0]non-5-ene (DBN), 1,8-Diazabicyclo[5.4.0]undec-7-ene zugegeben werden.

Zur Verbesserung der Siebdruckfähigkeit, Dispergierbarkeit, Vermeidung von Defekten und Bernard'schen Zellen können der Beschichtungslösung Hilfs- und Anpaststoffe, Entschäumer, Entlüfter, Nivellierer, Netz- und Dispergieradditive, Gleit-, Verlauf- und Substratnetzadditive zugegeben werden.

Je nach Beschichtungsverfahren können auch noch verschiedene Verlaufsmittel, Entschäumer, Entlüfter oder Dispergierungsadditive wie beispielsweise PEG, BYK 302, BYK 306, BYK 307, DC11, DC57 oder Airex 931 bzw. Airex 930 zugegeben werden, um homogene Schichtdicken und eine homogene Verteilung der Additive in der Beschichtung zu erreichen.

Wie vorstehend erwähnt wurde, wird erfindungsgemäß eine thermische Beständigkeit des Matrixmaterials ≥ 140° gefordert. Kennzeichen thermisch beständiger Matrixmaterialien ist, dass sie nach einer Temperaturbehandlung bei mindestens 140° C für 2 Stunden keine Vergilbung und keine signifikante Reduzierung der Transmission und keine signifikante Erhöhung des Flächenwiderstandes zeigen. Als signifikante Reduzierung der Transmission wird eine Transmissionsänderung größer 5 % angesehen. Als signifikante Erhöhung des Flächenwiderstandes wird eine Flächenwiderstandsänderung größer 10 % angesehen.

Als Sol-Gel-Ausgangsstoffe werden bevorzugt Metallalkoholate verwendet, bevorzugt Alkoxysilane, bspw. TEOS: Tetraethoxysilan, Aluminiumalkoholate, Titanalkoholate, Zirkonalkoholate und/oder Organometallalkoholate. Bevorzugt wird ein Tetraalkoxysilan Si(OR¹)₄ (mit R¹ = Methyl, Ethyl, Propyl, iso-Propyl, Butyl, sec. Butyl, Phenyl) oder ein Aluminiumalkoholat oder ein Titanalkoholat oder ein Zirkonalkoholat in Kombination mit einem Alkoxysilan Si(OR¹)₃R², welches eine organisch vernetzbare Funktionalität besitzt, eingesetzt (R²= Alkylkette funktionalisiert mit Glycidoxy, Methacryloxy, Acryl, Vinyl, Allyl, Amino, Mercapto, Isocyanato, Epoxy-, Acrylat-, Methacrylat-...). Organisch vernetzbare Alkoxysilane können bspw. sein GPTES: Glycidyoxypropyltriethoxysilan, MPTES: Methacryloxypropyltriethoxysilan, GPTMS: Glycidyloxypropyltrimethoxysilan, MPTMS: Methacryloxypropyltrimethoxysilan, VTES: Vinyltriethoxysilan, ATES: Allyltriethoxysilan, APTES: Aminopropyltriethoxysilan, MPTES: Mercaptopropyltriethoxysilan, ICPTES: 3-Isocyanatopropyltriethoxysilan. Wahlweise wird noch ein weiteres Metallalkoholat eingesetzt, bspw. Zr(OR¹)₄, Ti(OR¹)₄, Al(OR¹)₃, bspw. Zirkontetrapropylat, Titantetraethylat, Alumimiumsecundärbutylat. Wahlweise wird noch ein weiteres Organoalkoxysilan eingesetzt, bspw. Si(OR¹)₃R³, Si(OR¹)₂R³₂, Si(OR¹)R³₃ (mit R¹ = Methyl, Ethyl, Propyl, Butyl, sec. Butyl; R³: Methyl, Phenyl, Ethyl, iso-Propyl, Butyl, sec. Butyl), bspw. MTEOS: Methyltriethoxysilan, PhTEOS: Phenyltriethoxysilan, DEMDEOS: Dimethyldiethoxysilan. Die Herstellung des (Sol-Gel-)Hydrolysats erfolgt durch die gezielte Umsetzung der Monomere mit H₂O. Bevorzugt wird dies in Gegenwart einer Säure durchgeführt, bspw. HCl, H₂SO₄, Paratoluolsulfonsäure, Essigsäure. Die wässrige Hydrolyselösung hat bevorzugt einen pH < 4. In einer besonderen Ausführungsform kann die Hydrolyse auch in alkalischer Umgebung durchgeführt werden (z.B.: NH₃, NaOH). In einer weiteren speziellen Ausführungsform erfolgt die Hydrolyse mit einer wässrigen Nanopartikeldispersion. Der Vernetzungsgrad des Hydrolysates wird über das Verhältnis von H₂O zu hydrolysierbaren Monomeren eingestellt. Der Vernetzungsgrad beträgt dabei bevorzugt 5 - 50 %, bevorzugt 11 - 40 %, ganz besonders bevorzugt 15 - 35 %. Der Vernetzungsgrad wird über 29Si - NMR bestimmt. Die Viskosität des Hydrolysates liegt bei 5 - 30 mPas, bevorzugt 9 - 25 mPas. Der Restlösungsmittelgehalt liegt bei bevorzugt < 10 m-%.

Bevorzugt ist der Volumenanteil des Alkoxysilans mit organisch vernetzbarer Funktionalität so gewählt, dass die nanoskaligen Additive im flüssigen Zustand sterisch dispergiert sind, sich aber im ausgehärteten Zustand der Schicht berühren, also in elektrisch leitender Verbindung stehen.

Die Matrix kann dielektrisch oder nicht dielektrisch sein. In einer besonderen Ausführungsform kann das Matrixmaterial auch selbst leitfähig sein. Beispielweise kann es sich hierbei um sog. konjugierte Polymere, wie bspw. Poly(3,4-ethylenedioxythiophene) poly(styrenesulfonate) (PEDOT/PSS), v. a. aber temperaturbeständige Silane mit einem oder mehreren leitfähigen Resten, handeln.

Die Matrix kann zusätzlich Nanopartikel aus oxidischen Materialien wie TiO₂ (Anatas und/oder Rutil), ZrO₂ (amorpher, monokline und/oder tetragonale Phase), Ca oder Y₂O₃ dotiertes ZrO₂, MgO dotiertes ZrO₂, CeO₂, Gd₂O₃ dotiertes CeO₂, Y dotiertes ZrO₂, SiO₂, B₂O₃, Al₂O₃ (α-, γ- oder amorphe Form), SnO₂, ZnO, Bi₂O₃, Li₂O, K₂O, SrO, NaO, CaO, BaO, La₂O₃ und/oder HfO₂, Böhmit, Andalusit, Mullit und deren Mischoxide enthalten. Bevorzugt kann die Matrix SiO₂-haltige Nanopartikel enthalten.

Die Matrix weist einen Brechungsindex im Bereich von 1,4 bis 1,6, bevorzugt im Bereich von 1,45 bis 1,57 auf.

Die transparente leitfähige Schicht weist vorzugsweise eine Dicke von 10 nm bis 500 µm, bevorzugt 20 nm bis 100 µm, besonders bevorzugt 100 nm bis 10 µm auf.

Die Lichttransmission des transparenten elektrischen Leiters, bestehend aus Substrat und leitfähiger Schicht, beträgt bei einer Substratdicke von 4 mm und Wellenlängen größer 450 nm mindestens 75 %, vorzugsweise 85 %, besonders bevorzugt 90 % der Transmission des Substrats (gemessen mit einem Transparenzmessgerät (haze-gard plus) gemäß ASTM D 1003).

Der Haze-Wert des transparenten elektrischen Leiters, bestehend aus Substrat und leitfähiger Schicht, sollte kleiner als 15 %, bevorzugt kleiner 5 %, besonders bevorzugt < 3 % sein (gemessen mit einem Transparenzmessgerät (haze-gard plus) gemäß ASTM D 1003).

Die hochleitfähigen Additive sind zumeist anorganische Materialien/Partikel (Metalle, Legierungen, nichtoxidische und oxidische Materialien), welche bevorzugt eine faserartige Morphologie aufweisen.

Das Aspektverhältnis (Länge zu Durchmesser) der faserartigen Partikel ist dabei größer 10, bevorzugt größer 100, ganz besonders bevorzugt größer 200. Das mittlere Aspektverhälnis wird anhand von rasterelektronenenmikroskopischen Aufnahmen von 50 Fasern bestimmt.

Das Aspektverhältnis liegt dabei zwischen 10 - 100000, bevorzugt 50 - 10000, ganz besonders bevorzugt 85 - 1000.

Der mittlere Durchmesser der faserartigen Additive ist dabei kleiner 500 nm, bevorzugt kleiner 200 nm, besonders bevorzugt kleiner 100 nm.

Der mittlere Durchmesser liegt dabei bevorzugt zwischen 40 - 150 nm, besonders bevorzugt 50 - 100 nm. Der mittlere Durchmesser wird anhand von rasterelektronenenmikroskopischen Aufnahmen von 100 Fasern bestimmt.

Das hochleitfähige Additiv besteht bevorzugt aus einem Material mit einer elektrischen Leitfähigkeit von größer 10⁴ S/m, bevorzugt größer 3*10⁷ S/m, besonders bevorzugt größer 5*10⁷ S/m.

In der bevorzugten Ausführungsform weist das bevorzugte Material der Leitfähigkeitsadditive im Bulkzustand (Dicke kleiner 100 µm, bevorzugt kleiner 10 µm, besonders bevorzugt kleiner 1 µm) eine Transmission kleiner 10 %, bevorzugt 5 %, besonders bevorzugt kleiner 1 % auf. Das bedeutet, dass bevorzugt Materialien eingesetzt werden, welche schon bei einer geringen Materialdicke eine nahezu 100%ige Absorption des sichtbaren Lichtes zeigen.

Als Leitfähigkeitsadditiv können metallische Nanodrähte oder Nanoröhren (beispielweise aus Silber, Kupfer, Gold, Aluminium, Nickel, Platin, Palladium etc. und ihre Legierungen (z.B. AuAg), beschichtete metallische Nanodrähte (z.B. Nickelbeschichtete Kupfer-Nanodrähte; Polymer-beschichtete metallische Nanodrähte), leitfähige dotierte Oxidpartikel und/oder Nanodrähte (ITO, AZO, ATO, etc.), Kohlenstoffnano- und -mikromaterialien (z.B. einwandige und mehrwandige Kohlenstoffnanoröhren, Graphene, Ruß), anorganisch nichtoxidische Nanodrähte (z.B. Metallchalcogenide), Fasern aus leitfähigen Polymeren sowie Kombinationen dieser Leitfähigkeitsadditive eingesetzt werden. Besonders bevorzugt werden metallische Nanodrähte aus Silber oder Kupfer eingesetzt.

In einer speziellen Ausführungsform sind die leitfähigen Additive durch eine Barrierebeschichtung bzw. eine hochtransparente Versiegelungsschicht beschichtet, die die allmähliche Degradation mit der Zeit verhindert und Langzeitstabilität erhöht. Als Barrierebeschichtung kommen organische sowie anorganische Materialien zu Einsatz; insbesondere werden hier bspw. perfluorierte Polymere, Parylene, Poly(vinylpyrrolidon), Sol-Gel-Materialien sowie Metalle (bspw. mit verminderter Oxidationsneigung, wie z.B. Nickel) eingesetzt.

In einer besonderen Ausführungsform werden Leitfähigkeitsadditive eingesetzt welche zur besseren Dispergierung oberflächlich modifiziert sind. Beispielsweise können hierfür oberflächenaktive Tenside oder Oligomere/Polymere eingesetzt werden.

Der Volumenanteil des Leitfähigkeitsadditivs innerhalb des transparenten leitfähigen Materials liegt dabei zwischen 0,1-30%, bevorzugt zwischen 0,2-15%, besonders bevorzugt zwischen 0,4-10%.

Im Folgenden werden Verfahren zur Herstellung ausgewählter Leitfähigkeitsadditive skizziert:
- Ag-Nanodrähte können in großen Mengen über die "Polyol-Synthese" durch Flüssigphasenreduktion von Silbersalzen (z. B. Silbernitrat) unter Beteiligung eines Polyols (z.B. Ethylenglycol) dargestellt werden. Dabei wird das anisotrope Wachstum von Nanodrähten durch Zugabe von Poly(vinyl-pyrrolidon) (PVP) erreicht, welches das Wachstum verschiedener Facetten der Silberkristalle kinetisch behindert/kontrolliert. Silbernanodrähte mit Durchmesser von ca. 40 bis 120 nm und einem Aspektverhältnis bis zu 1000 können auf die Weise hergestellt werden. Mit zusätzlicher Lufteinperlung kann der Ausbeute an Ag-Nanodrähten deutlich erhöht werden.
- Cu-Nanodrähte mit hohem Aspektverhätnis können über Elektrospinnen erzeugt werden. Zunächst wird eine Lösung aus Kupferacetat und Poly(vinyl acetat) auf ein Glassubstrat elektrogesponnen. Diese Fasern haben einen Durchmesser von ca. 200 nm. In einem zweiten Schritt werden die kupferhaltigen Polymerfasern auf 500 °C an Luft erhitzt (2h) um die organischen Bestandteile zu entfernen. Die so entstandenen dunkelbraunen CuO-Nanodrähte werden dann durch einen Heizschritt bei 300 °C (1 h) in Wasserstoff zu (rotem) metallischem Kupfer reduziert. - Die Herstellung von Cu-Nanodrähten ist weiterhin über Hydrothermalsynthese möglich. Dabei wird beispielsweise Kupfer(II)chlorid in einer wässrigen Lösung von Octadecylamin (ODA) unter hydrothermalen Bedingungen bei 120-180°C reduziert. Bei hohen Temperaturen (180°C) und erhöhter ODA-Konzentration entstehen einkristalline Cu-Nanodrähte mit Durchmessern im Bereich von 50 nm ≤ d ≤ 100 nm und einem Aspektverhältnis größer 10⁵.
- Die Herstellung von Cu-Nanodrähten über die Reduktion von Cu(NO₃)₂ in einer wässrigen Lösung von Hydrazin, NaOH und Ethylendiamin wurde ebenfalls berichtet. Diese Methode ist geeignet große Mengen Cu-Nanodrähte herzustellen. In einem weiteren Schritt können die Drähte auch mit einer Nickelschicht umhüllt werden, wodurch die Oxidationsbeständigkeit erhöht wird.

Die nanoskaligen Additiven können in einem geeigneten Lösungsmittel dispergiert vorliegen, bspw. Ethanol oder Isopropanol.

Überraschenderweise wurde festgestellt, dass besonders gute optoelektrische Eigenschaften erzielt werden, wenn das Zetapotial des Matrixmaterials an das Zetapotential der Dispersion der nanoskaligen Additive angepasst ist. Einerseits kann das Zetapotential des Matrixmaterials beispielsweise durch Variation der Sol-Gel-Ausgangsstoffe und/oder durch Dotierung mit einem weiteren Sol-Gel-Ausgangsstoff, beispielsweise einem Metallalkoholat, einem Metallhydroxid, einem Metallhalogenid, einem Metallnitrat, einem Metallacetylacetonat, einem Metallacetat, einem Metallcarbonat und/oder einem Metalloxid, angepasst werden. Dabei kann das Metall in diesen Metallverbindungen ein Schwer- oder ein Leichtmetall sein. Die Anpassung des Zetapotential des Matrixmaterials kann außerdem durch Zugabe eines geeigneten Dispergierhilfsmittels erfolgen. Andererseits kann das Zetapotential der Dispersion der nanoskaligen Additive durch Zugabe eines geeigneten Dispergierhilfsmittels angepasst werden, z.B. durch Zugabe einer Säure, beispielsweise Paratoluolsulfonsäure, einer polyvalenten Säure, beispielsweise Citronensäure, Polyacrylsäure, oder einer Base, beispielsweise Polyethylenimin. Als besonders vorteilhaft erweist sich eine Anpassung zu positiven Zetapotentialen.

Durch die gezielte Verwendung eines temperaturbeständigem Substrats sowie einer temperaturbeständigen Matrix und hochleitfähige Partikeln mit faserartiger Geometrie wird ein transparenter elektrischer Leiter bereitgestellt, welcher sowohl eine geringen Flächenwiderstand als auch eine ausreichend hohe Transmission bei gleichzeitig hoher Temperaturbeständigkeit zeigt.

Für das Substrat werden Spezialglassubstrate bevorzugt. Solche Spezialglassubstrate können Glaskeramiken, insbesondere transparent eingefärbte Lithiumalumosilikat(LAS)-Glaskeramiken, transparente LAS-Glaskeramiken oder Magnesiumalumosilikat-Glaskeramiken oder Lithiumdisilikat-Glaskeramiken, oder Silikatgläser, beispielsweise Borosilikatgläser, Zink-Borosilikatgläser, Boroalumosilikatgläser, Alumosilikatgläser, alkalifreie Gläser, Kalk-Natron-Gläser, oder ein aus den vorgenannten Gläsern und/oder Glaskeramiken gebildeter Verbundwerkstoff sein.

Bevorzugt wird eine thermoschockbeständiges Spezialglas oder eine Glaskeramik mit einem thermischen Ausdehnungskoeffizienten kleiner 4,0·10⁻⁶/K, bevorzugt kleiner 3,4·10⁻⁶/K verwendet. Bevorzugt wird ein Borosilikatglas oder eine Lithiumalumosilikatglaskeramik mit Hochquarzmischkristallphase bzw. Keatit verwendet. Der Kristallphasengehalt liegt dabei zwischen 60 - 85 %.

Die verwendeten Substrate enthalten bevorzugt weniger als 1000 ppm, besonders bevorzugt weniger als 500 ppm, ganz besonders bevorzugt weniger als 200 ppm Arsen und/oder Antimon. In einer Ausführungsform ist die verwendete Glaskeramik Arsen- und Antimonfrei.

In einer besonderen Ausführungsform wird ein vorgespanntes Spezialglassubstrat verwendet, insbesondere Boroalumosilikatgläser (bspw. SCHOTT Xensation^{™}, Corning Gorilla^{™} I-III, Asahi Dragontrail^{™}). Die Vorspannung kann dabei chemisch bzw. thermisch induziert sein.

Das Substrat kann dabei starr oder flexibel sein.

Das Substrat kann dabei planar oder gebogen oder verformt sein.

Das Substrat kann mechanisch bearbeitete oder auch geätzte Oberflächen aufweisen.

Bevorzugte Dicken des Substrats liegen im Bereich von 10 µm bis 6 cm, besonders bevorzugt 30 µm bis 2 cm, ganz besonders bevorzugt 50 µm bis 6 mm, insbesondere bevorzugt 1 mm bis 6 mm.

Es können beidseitig glatt oder auch einseitig genoppte Substrate verwendet werden, wobei insbesondere die genoppten Substrate mit einer Ausgleichsschicht (z.B. aus PU oder Silikonen oder Silikonharzen) versehen werden, die die Gebrauchseigenschaften erfüllt.

Bei transparenten Spezialglassubstraten liegt die Lichttransmission des Substrats bei 4 mm Substratdicke und Wellenlängen größer 450 nm im sichtbaren Bereich größer 80 %, bevorzugt größer 90 %. Die Lichttransmission des beschichteten Spezialglassubstrats (Substrat und transparent leitfähige Schicht) im sichtbaren Bereich ist größer 60 %, bevorzugt größer 70 %, ganz bevorzugt größer 85 %. Das beschichtete Spezialglassubstrat ist weiterhin dadurch gekennzeichnet, dass der Hazewert kleiner 15 %, bevorzugt kleiner 5 %, ganz bevorzugt kleiner 3 % ist.

Bei Spezialglassubstraten bestehend aus transparent eingefärbter Glaskeramik liegt die Lichtdurchlässigkeit des Substrats im Sichtbaren (Lichtdurchlässigkeit gemäß ISO 9050:2003, 380-780 nm) bei einer Substratdicke von 4 mm bei 0,8-10 %. Das beschichtete Spezialglassubstrat ist dabei durch eine Transmission von 0,6 - 9 % im Sichtbaren ausgezeichnet. Die Transmission des Spezialglassubstrats liegt im Infraroten im Bereich von 850 nm bis 970 nm bei ≥ 45 %. Die Transmission des beschichteten Spezialglassubstrats liegt im Infraroten im Bereich von 820 nm bis 970 nm bei ≥ 40%.

Bevorzugt werden Substratgläser verwendet, wie sie im Bereich der weißen Ware bzw. Haushaltsgeräte eingesetzt werden, beispielsweise für Back- und Gargeräte, Mikrowellen, Kühlschränke, Dampfgarer, Bedienblenden für derartige Geräte, Gaskochgeräte, Spülen oder Geschirrspülgeräte. Besonders bevorzugt werden Substratgläser verwendet, wie sie für Kochfelder, Ofenscheiben oder Kaminsichtscheiben eingesetzt werden.

Als (Beschichtungs-)Verfahren zum Auftragen der Matrixvorstufe mit den darin dispergierten Leitfähigkeitsadditiven (also dem Beschichtungsmatrial) werden bevorzugt Druckverfahren, insbesondere Siebdruck, Rakeln, Inkjet, Off-Set-Druck oder Tampondruck, sowie Sprühverfahren, Roll-Coating und Spin-Coating eingesetzt.

Die Härtung der transparenten leitfähigen Schicht kann durch UV-Bestrahlung oder thermisch erfolgen. Im Falle einer thermischen Aushärtung im Temperaturbereich von 150-500°C für 10 min bis 3 h wird diese so durchgeführt, dass ein Versintern bzw. Anschmelzen sich berührender Leitfähigkeitsadditive auftreten kann, wodurch Kontaktwiderstände zwischen den Leitfähigkeitsadditiven vermindert werden. Ein solches Versintern bzw. Anschmelzen ist rasterelektronenmikroskopisch nachweisbar.

In einer bevorzugten Ausführungsform (bei UV und thermischer Härtung) kann eine zusätzliche thermische Nachbehandlung bei 150-500°C, bevorzugt bei 200-250°C, für 5 min - 4h, bevorzugt 10 min - 2h, besonders bevorzugt für 20 min - 1 h, durchgeführt werden, um ein Versintern oder eine Verbreiterung/Vergrößerung der Sinterbereiche zu erreichen. Weiterhin kann (während der Härtung bzw. Trocknung) zusätzlich ein Druck, bevorzugt > 1 bar, aufgebracht werden, um die Konnektivität der Leitfähigkeitsadditive zu erhöhen. In einer weiteren Ausführungsform wird der Schrumpf der Matrix während der Trocknung zur Konnektivitätssteigerung genutzt.

In einer weiteren bevorzugten Ausführungsform wird die Lösung der Leitfähigkeitsadditive vor der Zugabe zum Matrixmaterial druckfiltriert und/oder zentrifugiert, wodurch zum einen Rückstände, wie hochsiedende Lösungsmittel, Stabilisatoren und Nanopartikel, entfernt werden können und zum anderen auch ein Anpressen der Leitfähigkeitsadditive untereinander für eine bessere elektrische Konnektivität erreicht werden kann.

In einer weiteren besonderen Ausführungsform wird eine Konnektivitätssteigerung durch Einsatz eines leitfähigen Polymers als Matrixmaterial bzw. als Mantelmaterial für die Nanodrähte erreicht.

Das Substrat ist dabei bevorzugt im Displaybereich bzw. im Kaltbereich der Kochfläche mit der transparenten leitfähigen Schicht beschichtet.

Das mit einer transparenten leitfähigen Schicht versehene Substrat dient bevorzugt dazu eine touchdisplayfähige Kochfläche bereitzustellen.

Das Substrat wird dabei bevorzugt auf der Unterseite mit einer transparenten leitfähigen Schicht versehen.

Der transparente elektrische Leiter ist dabei dadurch gekennzeichnet, dass das aufgebrachte Beschichtungsmaterial (Matrixmaterial plus nanoskalige Additive) einen Flächenwiederstand kleiner 500 Ohm/sq, bevorzugt kleiner 250 Ohm/sq, ganz besonders bevorzugt kleiner 150 Ohm/sq aufweist (gemessen gemäß der Vier-Punkt-Methode und/oder der Wirbelstrommethode).

Die Erfindung ermöglicht es durch die gezielte Verwendung von Matrix und hochleitfähigen Partikeln mit faserartiger Geometrie, einen transparenten elektrischen Leiter bereitzustellen, dass eine transparente leitfähige Schicht aufweist, die in einem einfachen Beschichtungsverfahren aufgebracht werden kann und einen geringen Flächenwiderstand, eine hohe Transmission und eine hohe Temperatur- und Korrosionsbeständigkeit zeigt.

Die transparente leitfähige Schicht kann in einem oder mehreren Teilbereichen auf dem Substrat lateral strukturiert (bspw. im nm-, µm-, mm-, oder cm-Bereich) oder vollflächig aufgebracht werden. Eine derartige Strukturierung ermöglicht beispielsweise die Realisierung von Einzeltouch-Sensorenelektroden oder strukturierten Feldern aus Einzeltouch-Sensorelektroden im Kaltbereich eines Kochfeldes. Eine vollflächige Aufbringung der transparenten leitfähigen Schicht, bevorzugt in einem Teilbereich des Substrats, ermöglicht es beispielsweise ein Touchfeld (Touchscreen) mit Ortauflösung bereitzustellen, bei dem beispielhaft die Ortsauflösung durch Auswertung der Differenzsignale an den Ecken erreicht wird.

In einer bevorzugten Ausführungsform wird ein transparentes Substrat, mit einer oder mehreren dekorativen Beschichtungen, wie beispielsweise farbige oder transparente Dekore, versehen, wobei farbige Dekore pigmentiert sein können. In einer weiteren bevorzugten Ausführungsform wird ein transparentes Substrat, mit einer oder mehreren funktionalen Beschichtungen versehen, verwendet. Diese dekorativen und/oder funktionalen Beschichtungen können sich dabei auf der gleichen Seite wie das transparent leitfähige Beschichtungsmaterial oder auf der gegenüberliegenden Seite befinden. Die weiteren Beschichtungen können dabei sowohl vollflächig als auch strukturiert, wie bspw. als Kochzonenmarkierung bzw. mit einer Aussparung für ein Display, aufgebracht sein.

Ferner können auf das Substrat mehrere Lagen der transparenten leitfähigen Schicht aufgebracht werden. In einer besonderen Ausführungsform befindet sich zwischen mehreren leitfähigen Schichten eine dielektrische Schicht und/oder eine als Antireflektionsschicht wirksame Schicht. Beispielsweise kann die Antireflexionsschicht aus Siliziumoxid und/oder Siliziumnitrid bestehen. Ein derartiger Schichtaufbau ermöglicht es beispielsweise ortsaufgelöste kapazitive Multitouchsensoren zu realisieren.

### Ausführungsbeispiel 1:

Zur Herstellung von Silbernanodrähten wird das Lösungs- und Reduktionsmittel Ethylenglykol vorgelegt und auf eine Temperatur von 130°C gebracht. Danach werden eine 0,25 molare Polyvinylpyyrolidon (PVP) - Lösung und eine 0,25 molare Silbernitrat-Lösung zugegeben sowie weitere Additive, beispielsweise Salzlösungen, zugegeben. Nach einer Synthesedauer von zwei Stunden werden Silbernanodrähte mit einem mittleren Durchmesser von 95 nm und einer mittlere Länge von 25 µm erhalten. Das Ethylenglykol sowie das PVP werden über mehrere Zentrifugierschritte entfernt und durch Ethanol ersetzt. Die ethanolische Silbernanodrahtdispersion wird mit einem Sol-Gel-Binder basierend auf Tetraethoxysilan im Verhältnis 8:1 in einem Kolben vermischt und gerührt. Mit einer Spiralhantel wird der Beschichtungslack auf eine transparente Glaskeramik (SCHOTT Ceran Cleartrans®) aufgetragen und eine Naßfilmschichtdicke von ≤ 10 µm erzeugt. Nach thermischer Aushärtung bei 200 °C für eine Stunde wird eine transparente leitfähige Schicht mit einer Schichtdicke von 0,5 µm und einem Volumenanteil an Silbernanodrähten von ca. 2 % erhalten. Der Flächenwiderstand beträgt 12 Ohm/sq. Die Transmission liegt bei 80 % und der Hazewert bei 13%.

### Ausführungsbeispiel 2:

Die ethanolische Silbernanodrahtdispersion gemäß Ausführungsbeispiel 1 wird mit einem Sol-Gel-Binder basierend auf Tetraethoxysilan im Verhältnis 2:1 in einem Kolben vermischt und gerührt. Mit einer Spiralhantel wird der Beschichtungslack auf eine transparente Glaskeramik (SCHOTT Ceran Cleartrans®) aufgetragen und eine Naßfilmschichtdicke von ≤ 10 µm erzeugt. Nach thermischer Aushärtung bei 200 °C für eine Stunde wird eine transparente leitfähige Schicht mit einer Schichtdicke von 0,6 µm und einem Volumenanteil an Silbernanodrähten von ca. 0,5 % erhalten. Der Flächenwiderstand beträgt 40 Ohm/sq. Die Transmission liegt bei 82 % und der Hazewert bei 9 %.

### Ausführungsbeispiel 3:

Die ethanolische Silbernanodrahtdispersion gemäß Ausführungsbeispiel 1 wird mit einem Sol-Gel-Binder basierend auf Tetraethoxysilan im Verhältnis 2:1 in einem Kolben vermischt und gerührt. Mit einer Spiralhantel wird der Beschichtungslack auf ein Boroalumosilikatgläser (SCHOTT Xensation^{™}) aufgetragen und eine Naßfilmschichtdicke von ≤ 10 µm erzeugt. Nach thermischer Aushärtung bei 200 °C für eine Stunde wird eine transparente leitfähige Schicht mit einer Schichtdicke von 0,6 µm und einem Volumenanteil an Silbernanodrähten von ca. 0,5 % erhalten. Der Flächenwiderstand beträgt 40 Ohm/sq. Die Transmission liegt bei 81 % und der Hazewert bei 8 %.

### Ausführungsbeispiel 4:

Es wird eine kommerziell erhältliche ethanolische Silbernanodrahtdispersion mit Nanodrähten eines mittleren Drahtdurchmessers von 40 nm und einer mittleren Drahtlänge von 35 µm und ein Sol-Gel-Binder basierend auf Tetraethoxysilan im Verhältnis 4:1 in einem Kolben vermischt und gerührt. Mit einer Spiralhantel wird der Beschichtungslack auf eine transparente Glaskeramik (SCHOTT Ceran Cleartrans®) aufgetragen und eine Naßfilmschichtdicke von ≤ 10 µm erzeugt. Nach thermischer Aushärtung bei 200 °C für eine Stunde wird eine transparente leitfähige Schicht mit einer Schichtdicke von 0,6 µm und einem Volumenanteil an Silbernanodrähten von ca. 1 % erhalten. Der Flächenwiderstand beträgt 10 Ohm/sq. Die Transmission liegt bei 82 % und der Hazewert bei 9 %.

### Ausführungsbeispiel 5:

Es wird eine kommerziell erhältliche ethanolische Silbernanodrahtdispersion mit Nanodrähten eines mittleren Drahtdurchmessers von 40 nm und einer mittleren Drahtlänge von 35 µm und eine Silikonharzlösung (SILRES® REN80) im Verhältnis 4:1 in einem Kolben vermischt und gerührt. Mit einer Spiralhantel wird der Beschichtungslack auf eine transparente Glaskeramik (SCHOTT Ceran Cleartrans®) aufgetragen und eine Naßfilmschichtdicke von ≤ 10 µm erzeugt. Nach thermischer Aushärtung bei 200 °C für eine Stunde wird eine transparente leitfähige Schicht mit einer Schichtdicke von 0,7 µm und einem Volumenanteil an Silbernanodrähten von ca. 1 % erhalten. Der Flächenwiderstand beträgt 14 Ohm/sq. Die Transmission liegt bei 84 % und der Hazewert bei 8 %.

### Ausführungsbeispiel 6:

Es werden eine kommerziell erhältliche ethanolische Silbernanodrahtdispersion mit Nanodrähten eines mittleren Drahtdurchmessers von 40 nm und einer mittleren Drahtlänge von 35 µm und ein Sol-Gel-Binder basierend auf Aluminiumsekundärbutylat im Verhältnis 1:4 in einem Kolben vermischt und gerührt. Mit einer Spiralhantel wird der Beschichtungslack auf eine transparente Glaskeramik (SCHOTT Ceran Cleartrans®) aufgetragen und eine Nassfilmschichtdicke von ≤ 10 µm erzeugt. Nach thermischer Aushärtung bei 200 °C für eine Stunde wird eine transparente leitfähige Schicht mit einer Schichtdicke von 0,2 µm erhalten. Der Flächenwiderstand beträgt 35 Ohm/sq. Die Transmission liegt bei 83 % und der Hazewert bei 4 %.

### Ausführungsbeispiel 7:

Es wird eine kommerziell erhältliche ethanolische Silbernanodrahtdispersion mit Nanodrähten eines mittleren Drahtdurchmessers von 40 nm und einer mittleren Drahtlänge von 35 µm zentrifugiert. Nach dem Dekantieren des Ethanols wird Terpineol als hochsiedendes Lösungsmittel hinzugegeben. Die Silbernanodrahtdispersion wird mit einem Sol-Gel-Binder basierend auf Aluminiumsekundärbutylat im Verhältnis 40:1 in einem Kolben vermischt und gerührt. Mit einer Spiralhantel wird der Beschichtungslack auf eine transparente Glaskeramik (SCHOTT Ceran Cleartrans®) aufgetragen und eine Nassfilmschichtdicke von ≤ 10 µm erzeugt. Nach thermischer Aushärtung bei 200 °C für neunzig Minuten wird eine transparente leitfähige Schicht erhalten. Der Flächenwiderstand beträgt 8 Ohm/sq. Die Transmission liegt bei 73 % und der Hazewert bei 14 %.

### Ausführungsbeispiel 8:

Es wird eine kommerziell erhältliche ethanolische Silbernanodrahtdispersion mit Nanodrähten eines mittleren Drahtdurchmessers von 40 nm und einer mittleren Drahtlänge von 35 µm zentrifugiert. Nach dem Dekantieren des Ethanols wird ein Terpineol-Ethanol-Gemisch im Volumenverhältnis 1:1 als Lösungsmittel hinzugegeben. Die Silbernanodrahtdispersion wird mit einem Sol-Gel-Binder basierend auf Aluminiumsekundärbutylat im Verhältnis 40:1 vermischt und gerührt. Mit einer Spiralhantel wird der Beschichtungslack auf eine transparente Glaskeramik (SCHOTT Ceran Cleartrans®) aufgetragen und eine Nassfilmschichtdicke von ≤ 10 µm erzeugt. Nach thermischer Aushärtung bei 200 °C für neunzig Minuten wird eine transparente leitfähige Schicht erhalten. Der Flächenwiderstand beträgt 150 Ohm/sq. Die Transmission liegt bei 80 % und der Hazewert bei 9 %.

### Ausführungsbeispiel 9:

Es werden eine kommerziell erhältliche ethanolische Silbernanodrahtdispersion mit Nanodrähten eines mittleren Drahtdurchmessers von 40 nm und einer mittleren Drahtlänge von 35 µm und ein Sol-Gel-Binder basierend auf Tetraethoxysilan als SiO2-Präkursor und Natriumhydroxid als Katalysator im Verhältnis 20:1 in einem Kolben vermischt und gerührt. Mit einer Spiralhantel wird der Beschichtungslack auf eine transparente Glaskeramik (SCHOTT Ceran Cleartrans®) aufgetragen und eine Nassfilmschichtdicke von ≤ 10 µm erzeugt. Nach thermischer Aushärtung bei 200 °C für eine Stunde wird eine transparente leitfähige Schicht erhalten. Der Flächenwiderstand beträgt 41 Ohm/sq. Die Transmission liegt bei 83 % und der Hazewert bei 8 %.

### Ausführungsbeispiel 10:

Es werden eine kommerziell erhältliche ethanolische Silbernanodrahtdispersion mit Nanodrähten eines mittleren Drahtdurchmessers von 40 nm und einer mittleren Drahtlänge von 35 µm und ein Sol-Gel-Binder basierend auf Tetraethoxysilan als SiO2-Präkursor und wässriger Ammoniaklösung als Katalysator im Verhältnis 20:1 in einem Kolben vermischt und gerührt. Mit einer Spiralhantel wird der Beschichtungslack auf eine transparente Glaskeramik (SCHOTT Ceran Cleartrans®) aufgetragen und eine Nassfilmschichtdicke von ≤ 10 µm erzeugt. Nach thermischer Aushärtung bei 200 °C für eine Stunde wird eine transparente leitfähige Schicht erhalten. Der Flächenwiderstand beträgt 21 Ohm/sq. Die Transmission liegt bei 78 % und der Hazewert bei 9 %.

### Ausführungsbeispiel 11:

Es wird eine kommerziell erhältliche ethanolische Silbernanodrahtdispersion mit Nanodrähten eines mittleren Drahtdurchmessers von 40 nm und einer mittleren Drahtlänge von 35 µm und ein basisch katalysierter Sol-Gel-Binder basierend auf Tetraethoxysilan und Methyltriethoxysilan als SiO2-Präkursoren im Verhältnis 2:1 in einem Kolben vermischt und gerührt. Mit einer Spiralhantel wird der Beschichtungslack auf eine transparente Glaskeramik (SCHOTT Ceran Cleartrans®) aufgetragen und eine Nassfilmschichtdicke von ≤ 10 µm erzeugt. Nach thermischer Aushärtung bei 420 °C für zehn Minuten wird eine transparente leitfähige Schicht erhalten. Der Flächenwiderstand beträgt 34 Ohm/sq. Die Transmission liegt bei 86 % und der Hazewert bei 3 %.

Die Erfindung wird im Folgenden anhand von in den Zeichnungen dargestellten Ausführungsbeispielen näher erläutert. Es zeigt:
- Fig. 1: in schematischer Seitenansicht einen elektrisch leitfähigen, transparenten Leiter,
- Fig. 2: eine alternative Ausgestaltungsvariante eines transparenten elektrischen Leiters in Seitenansicht und schematischer Darstellung,
- Fig. 3: eine weitere Alternative eines transparenten elektrischen Leiters in Seitenansicht und schematischer Darstellung,
- Fig. 4: in Aufsicht eine Kochfläche, die in einem Teilbereich mit einer strukturierten transparenten leitfähigen Schicht beschichtet ist,
- Fig. 5: in Aufsicht eine Kochfläche, die in einem Teilbereich vollflächig mit einer transparenten leitfähigen Schicht beschichtet ist und
- Fig. 6: in perspektivischer Darstellung eine Ansicht auf die Rückseite einer Kochfläche mit zwei strukturierten transparenten leitfähigen Schichten, die durch eine elektrisch isolierende Schicht getrennt sind.

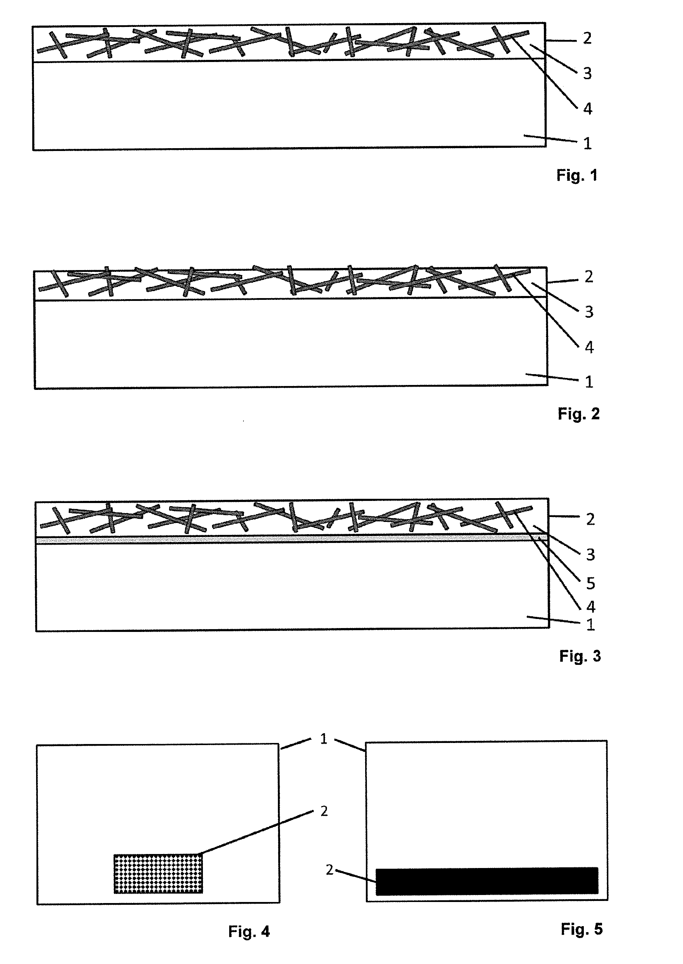

Fig. 1 zeigt ein transparentes Substrat 1, bestehend aus Glas oder Glaskeramik auf das eine leitfähige Schicht 2 aufgebracht ist. Die leitfähige Schicht 2 besteht aus einer Matrixschicht 3 in der hochleitfähige Additive 4 in Form von Nanodrähten oder Nanoröhrchen eingebettet sind. Diese Additive 4 liegen in Form eines Netzwerks vor und stehen miteinander zur Bildung der leitfähigen Schicht in elektrisch leitender Verbindung.

Bei dem Ausführungsbeispiel nach Fig. 2 ist eine ähnliche Gestaltung wie bei Figur 1 gewählt, wobei jedoch einige der Additive über die Oberfläche der Matrixschicht 3 vorstehen um dort elektrisch kontaktiert werden zu können.

Gemäß dem Ausführungsbeispiel nach Fig. 3 ist zwischen der Substratoberfläche und der leitfähigen Schicht 2 eine Kontaktierung 5 vorgesehen. Zumindest ein Teil der Additive steht mit dieser Kontaktierung 5 in elektrisch leitender Weise in Verbindung. Die Kontaktierung 5 kann beispielsweise eine elektrisch leitfähige Metallschicht sein, die in einem Flüssigbeschichtungsverfahren strukturiert aufgebracht wird.

Die Fig. 4 und 5 zeigen zwei Ausführungsbeispiele eines transparenten elektrischen Leiters in Form einer Kochfläche. Dabei können auf die Unterseite eines Substrats 1, in der Regel bestehend aus Glaskeramik, leitfähige Schichten 2 aufgebracht sein. Während bei dem Ausführungsbeispiel nach Fig. 4 ein Teilbereich mit einer strukturierten transparenten leitfähigen Beschichtung vorgesehen ist, wird bei Fig. 5 eine vollflächige transparente leitfähige Beschichtung in einem Teilbereich der Kochfläche aufgebracht.

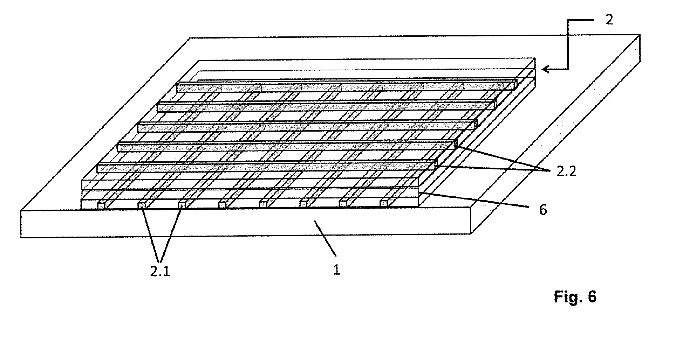

Fig. 6 zeigt ein Substrat 1 in Form eines Spezialglases, auf das zwei streifenförmig strukturierte transparente leitfähige Schichten 2.1 und 2.2 aufgebracht sind, wobei die Streifen zueinander kreuzweise angeordnet sind. Zwischen den Schichten 2.1 und 2.2 ist eine elektrisch isolierende Schicht 6 angeordnet. Auf diese Weise kann ein x-y auflösendes kapazitives Touchpanel realisiert werden.

## Patentansprüche

1. Transparenter elektrischer Leiter mit einem transparenten Substrat (1) und einer elektrisch leitfähigen Schicht (2) auf dem Substrat (1), wobei die leitfähige Schicht (2) eine Vielzahl von elektrisch leitfähigen, nanoskaligen Additiven (4) aufweist, wobei die Additive (4) miteinander in elektrisch leitender Verbindung stehen, um die elektrisch leitfähige Schicht (2) zu bilden, wobei das Substrat (1) von einem Glas- oder Glaskeramikwerkstoff oder einem Glas- und/oder Glaskeramik aufweisenden Verbundwerkstoff gebildet ist, wobei die Additive (4) zumindest bereichsweise in einer Matrixschicht (3) eingebettet sind, und wobei die Matrixschicht (3) von einem transparenten Matrixmaterial gebildet ist,
**dadurch gekennzeichnet,**
**dass** der transparente elektrische Leiter eine thermische Beständigkeit von mindestens 140 °C aufweist.

2. Transparenter elektrischer Leiter nach Anspruch 1,
**dadurch gekennzeichnet,**
**dass** die thermische Beständigkeit des transparenten elektrischen Leiters mindestens 180 °C, besonders bevorzugt mindestens 200 °C beträgt, und/oder
**dass** die Kratzbeständigkeit der elektrisch leitfähigen Schicht mindestens 500 g, vorzugsweise mindestens 700 g beträgt.

3. Transparenter elektrischer Leiter nach einem der Ansprüche 1 bis 2,
**dadurch gekennzeichnet,**
**dass** die Lichttransmission λ des transparenten elektrischen Leiters bei einer Substratdicke von 4 mm und Wellenlängen größer 450 nm mindestens 75 %, vorzugsweise 85 %, besonders bevorzugt 90 % der Transmission des Substrats beträgt und/oder
**dass** der Haze-Wert des transparenten elektrischen Leiters kleiner als 15 %, bevorzugt kleiner 5 %, besonders bevorzugt kleiner 3 % beträgt und/oder dass der Flächenwiderstand der elektrisch leitfähigen Schicht kleiner 500 Ohm/sq, bevorzugt kleiner 250 Ohm/sq, ganz besonders bevorzugt kleiner 150 Ohm/sq ist.

4. Transparenter elektrischer Leiter nach einem der Ansprüche 1 bis 3,
**dadurch gekennzeichnet,**
**dass** das Matrixmaterial UV- oder thermisch härtbare Polymere, Silikone, UV- oder thermisch organisch vernetzbare hybridpolymere Sol-Gel-Materialien, hybridpolymere Sol-Gel-Materialien, nanopartikelfunktionalisierte Sol-Gel-Materialien, Sol-Gel-Materialien mit nanopartikulären Füllstoffen, anorganische Sol-Gel-Materialien mit einer thermischen Beständigkeit von mindestens 140°C aufweist oder daraus vollständig besteht, wobei insbesondere vorgesehen sein kann,
**dass** das Matrixmaterial mindestens aus einem kondensierten und/oder hydrolysierten Monomer von Metall-Alkoholaten, bevorzugt Silizium-, Zirkon-, Titan-, Aluminium- und/oder Organometallalkoholaten, besteht und/oder dass ein Bestandteil des Matrixmaterials ein Tetraalkoxysilan Si(OR¹)₄ ist mit R¹ = Methyl, Ethyl, Propyl, iso-Propyl, Butyl, sec. Butyl, Phenyl, oder ein anderes Metall-Alkoholat ist,
bevorzugt in Kombination mit einem weiteren Alkoxysilan Si(OR¹)₃R², welches eine organisch vernetzbare Funktionalität besitzt (mit R²= Alkylkette funktionalisiert mit Glycidoxy, Methacryloxy, Acryl, Vinyl, Allyl, Amino, Mercapto, Isocyanato), und/oder einem weiteren Metallalkoholat und/oder einem weiteren Organoalkoxysilan Si(OR¹)₃R³ oder Si(OR¹)₂R³₂ oder Si(OR¹)R³₃ mit R³: Methyl, Phenyl, Ethyl, iso-Propyl, Butyl, sec. Butyl.

5. Transparenter elektrischer Leiter nach einem der Ansprüche 1 bis 4,
**dadurch gekennzeichnet,**
**dass** das Zetapotential des Matrixmaterials an das Zetapotential der Dispersion der nanoskaligen Additive angepasst ist, wobei insbesondere vorgesehen sein kann,
**dass** das Zetapotential des Matrixmaterials durch Variation der Sol-Gel-Ausgangsstoffe und/oder durch Dotierung mit einem weiteren Sol-Gel-Ausgangsstoff, beispielsweise einem Metallalkoholat, einem Metallhydroxid, einem Metallhalogenid, einem Metallnitrat, einem Metallacetylacetonat, einem Metallacetat, einem Metallcarbonat und/oder einem Metalloxid, angepasst wurde und/oder dass das Zetapotential des Matrixmaterials durch Zugabe eines geeigneten Dispergierhilfsmittels angepasst wurde oder
**dass** das Zetapotential der Dispersion der nanoskaligen Additive durch Zugabe eines geeigneten Dispergierhilfsmittels angepasst wurde, z.B. durch Zugabe einer Säure, beispielsweise Paratoluolsulfonsäure, einer polyvalenten Säure, beispielsweise Citronensäure, Polyacrylsäure, oder einer Base, beispielsweise Polyethylenimin.

6. Transparenter elektrischer Leiter nach einem der Ansprüche 4 bis 5,
**dadurch gekennzeichnet,**
**dass** der Volumenanteil des Alkoxysilans mit organisch vernetzbarer Funktionalität so gewählt ist, dass die nanoskaligen Additive im flüssigen Zustand sterisch dispergiert sind, sich aber im ausgehärteten Zustand berühren.

7. Transparenter elektrischer Leiter nach einem der Ansprüche 1 bis 6,
**dadurch gekennzeichnet,**
**dass** die elektrisch leitfähigen, nanoskaligen Additive eine faserartige Morphologie aufweisen und dass ihr Aspektverhältnis (Länge zu Durchmesser) im Bereich zwischen 10 - 100000, bevorzugt 50 - 10000, ganz besonders bevorzugt 85 - 1000 liegt und/oder
**dass** die elektrische Leitfähigkeit der Materialien, aus denen die nanoskaligen Additive bestehen, größer 10⁴ S/m, vorzugsweise > 3*10⁷ S/m, besonders bevorzugt > 5*10⁷ S/m beträgt.

8. Transparenter elektrischer Leiter nach einem der Ansprüche 1 bis 7,
**dadurch gekennzeichnet,**
**dass** die leitfähigen nanoskaligen Additive ein Metall oder eine Metallegierung, bevorzugt aus Silber, Kupfer oder Gold, enthalten oder aus ihnen bestehen und/oder
**dass** der mittlere Durchmesser der elektrisch leitfähigen nanoskaligen Additive im Bereich von 40 bis 150 nm, bevorzugt im Bereich von 60 bis 100 nm liegt.

9. Transparenter elektrischer Leiter nach einem der Ansprüche 1 bis 8,
**dadurch gekennzeichnet,**
**dass** die Additive (4) mittels einer Schicht, vorzugsweise aus einem Material mit verminderter Oxidationsneigung, beschichtet sind und/oder
**dass** das Substrat aus einer Glaskeramik, insbesondere einer eingefärbten Glaskeramik, besonders bevorzugt aus einer Lithiumalumosilikat (LAS)-Glaskeramik, einer Magnesiumalumosilikat-Glaskeramik, einem Silikatglas, einem Boroalumosilikatglas, einem Alumosilikatglas, einem alkalifreien Glas, einem Kalk-Natron-Glas oder einem aus den vorgenannten Gläsern und/oder Glaskeramiken gebildeten Verbundwerkstoff besteht und/oder dass das Substrat einen Ausdehnungskoeffizienten von kleiner 4,0·10⁻⁶/K, bevorzugt von kleiner 3,5·10⁻⁶/K, ganz besonders bevorzugt von kleiner 1,0·10⁻⁶/K aufweist.

10. Verfahren zur Herstellung eines transparenten elektrischen Leiters nach einem der Ansprüche 1 bis 9, wobei auf ein Substrat (1) mittelbar oder unmittelbar eine elektrisch leitfähige Schicht (2) enthaltend eine Vielzahl von elektrisch leitfähigen nanoskaligen Additiven (4) aufgebracht wird, wobei die Additive (4) zumindest bereichsweise in einer Matrixschicht (3), bestehend aus einem transparenten Material (3) eingebettet werden,
**dadurch gekennzeichnet,**
**dass** die Additive (4) in einem Matrixmaterial dispergiert werden, und dass das Matrixmaterial mit den darin dispergierten Additiven (4) als Beschichtungsmaterial auf das Substrat (1) aufgebracht wird.

11. Verfahren nach Anspruch 10,
**dadurch gekennzeichnet,**
**dass** die nanoskaligen Additive und/oder das Matrixmaterial vor dem Zusammenführen in dem Beschichtungsmaterial beide in mindestens einem niedrigsiedenden, mindestens einem hochsiedendem Lösungsmittel oder in einem Lösungsmittelgemisch bestehend aus mindestens einem niedrigsiedendem und mindestens einem hochsiedendem Lösungsmittel vorliegen und/oder dass das gehärtete Beschichtungsmaterial einer thermischen Nachbehandlung bei 150 bis 500°C, vorzugsweise 200 bis 250°C für 5 Minuten bis 4 Stunden, vorzugsweise 10 Minuten bis 2 Stunden unterzogen wird und/oder
**dass** ein Bestandteil des Matrixmaterials bevorzugt mindestens aus einem kondensierten und/oder hydrolysierten Monomer von Metall-Alkoholaten, bevorzugt Silizium-, Zirkon-, Titan-, Aluminium- und/oder Organometallalkoholaten, bevorzugt Si(OR)₄, SiR(OR)₃, oder SiR₂(OR)₂, mit R= organischer Funktionalität und OR=Alkoholatfunktionalität, besteht.

12. Verfahren nach einem der Ansprüche 10 bis 11,
**dadurch gekennzeichnet,**
**dass** das Beschichtungsmaterial eine Siebdruckfarbe oder ein Rakellack oder eine Inkjetdruckfarbe oder ein Sprühlack oder ein Roll-Coatinglack oder ein Spin-Coatinglack oder ein Tamponlack ist und/oder
**dass** das Beschichtungsmaterial auf ein aus Glas oder Glaskeramik bestehendes Substrat (1) oder auf ein Glas und/oder Glaskeramik aufweisenden Verbundwerkstoff als Substrat (1) aufgebracht wird und/oder
**dass** in dem Matrixmaterial metallische Nanodrähte oder Nanoröhren als Additive (4) dispergiert werden.

13. Verfahren nach einem der Ansprüche 10 bis 12,
**dadurch gekennzeichnet,**
**dass** zwei oder mehrere Schichten des Beschichtungsmaterials auf das Substrat (1) aufgebracht werden wobei insbesondere vorgesehen sein kann,
**dass** zwischen zwei Schichten von Beschichtungsmaterial eine Schicht aufweisend ein dielektrisches Material und/oder eine Antireflektionsschicht eingebracht wird.

14. Verfahren nach Anspruch 10 bis 13,
**dadurch gekennzeichnet,**
**dass** die transparente leitfähige Schicht in einem oder mehreren Teilbereichen auf dem Substrat lateral strukturiert aufgebracht wird und/oder
**dass** eine Konnektivitätssteigerung zwischen den nanoskaligen Additiven durch eine thermische Nachbehandlung bei 150 bis 500°C für 10 Minuten bis 3 Stunden oder durch eine Druckbehandlung während der Schichthärtung oder der thermische Nachbehandlung oder durch Ausnutzung des Matrixschrumpfs während der Schichthärtung oder durch Einsatz eines leitfähigen Polymers als Matrix- oder Mantelmaterial für die Additive erreicht wird.

15. Verwendung des transparenten elektrischen Leiters nach einem der Ansprüche 1 bis 20 als Teil eines Haushaltsgeräts, bevorzugt als Teil eines Displays oder Touchsensor im Kaltbereich eines Kochfeldes.
